# EUROPÄISCHE PATENTSCHRIFT

(11) **EP 1 525 427 B1**
(45) Veröffentlichungstag und Bekanntmachung des Hinweises auf die Patenterteilung: **14.07.2010**
(21) Anmeldenummer: 03771098.5
(22) Anmeldetag: 24.07.2003
(51) Int. Cl.: F28F 3/02, F28F 13/12, H05K 7/20

(54) **WÄRMETAUSCHERVORRICHTUNG**
HEAT-EXCHANGING DEVICE
DISPOSITIF ECHANGEUR DE CHALEUR

(30) Priorität: 24.07.2002 DE 10233736
(43) Veröffentlichungstag der Anmeldung: 27.04.2005
(73) Patentinhaber: NFT Nanofiltertechnik Gesellschaft mit beschränkter Haftung, 80802 München (DE)
(72) Erfinder: HOFMANN, Wilfried, 80801 München (DE)
(74) Vertreter: von Bülow, Tam
(86) Internationale Anmeldenummer: PCT/EP2003/008182
(87) Internationale Veröffentlichungsnummer: WO 2004/011867

(56) Entgegenhaltungen:
- DE-A- 3 929 004
- JP-A- 11 186 762
- US-A- 5 787 975
- US-A- 6 067 227

## Beschreibung

Die vorliegende Erfindung bezieht sich auf eine Wärmetauschervorrichtung gemäß dem Oberbegriff des Patentanspruches 1.

Eine derartige Wärmetauschervorrichtung ist aus der JP 11 186762 A bekannt. Dort ist eine Abdeckung für eine Wärmesenke beschrieben. Die Wärmesenke ist ein Kühlkörper mit einer horizontalen Grundplatte und mehreren davon senkrecht abstehenden Kühlrippen. Die Abdeckung für diese Wärmesenke ist ein kastenförmiges Teil mit rechteckigem Querschnitt, an dessen Oberseite mehrere in Anströmrichtung eines gerichteten Fluidstromes hintereinander liegende Stege angeordnet sind, wobei unmittelbar in Anströmrichtung vor den Stegen parallel zu diesen verlaufende Kanäle vorhanden sind, die sich durch die obere Abdeckplatte hindurch erstrecken. Die Stege sind gegen die Anströmrichtung geneigt und dienen dazu, längs der oberen Platte fließende Frischluft umzulenken, damit diese durch die Kanäle hindurch in das Innere der kastenförmigen Abdekkung gelangen kann. Der wesentliche Wärmeübergang erfolgt dabei von den genannten Rippen zu dem vorbeiströmenden Fluid.

Die DE 39 29 004 zeigt einen Wärmetauscher mit Doppelplatten, die an inneren und/oder äußeren Flächen Profilierungen aufweisen, die als quer zur Anströmrichtung liegende Sicken oder Stege ausgebildet sind. Diese Stege liegen in Anströmrichtung hintereinander und ihre Höhe ist kleiner als der Abstand von benachbarten Stegen. Die Stege sollen dabei Turbulenzen des strömenden Mediums und damit einen verbesserten wärmeübergang bewirken.

Die US-A 6,067,227 zeigt eine Kühleinrichtung für elektronische Bauelemente mit einem Grundkörper, von dem eine Vielzahl von Rippen oder Pfosten abstehen. Mittig über diesem Grundkörper ist ein Ventilator angebracht, der Kühlluft vertikal in Richtung zur Grundplatte fördert, die dann entlang der Rippen oder Pfosten entlangläuft und seitlich abgeführt wird.

Die DE 38 22 890 A1 zeigt eine Kühlanordnung mit einem Gebläse und einer Vielzahl von parallel zueinander angeordneten Kühlelementen, die jeweils langgestreckte Kühlstege und dazwischenliegende Spaltöffnungen aufweisen, wobei die Kühlstege von jeweils zwei benachbarten Kühlelementen gegeneinander versetzt sind, so daß in Anströmrichtung die Kühlstege eines Kühlelementes die Spaltöffnung des benachbarten Kühlelementes überdecken.

Die DE 198 13 119 A1 zeigt einen Turbulenzwärmerückgewinner mit Profilplatten, deren Profile in der Plattenebene alternierend entgegengerichtet um den gleichen Winkel gegen die Längsrichtung des Druckgradienten schräg gestellt sind. Hierdurch soll eine turbulente Strömung erzeugt werden, die die Wärmetauscherleistung verbessert.

Solche Wärmetauschervorrichtungen werden beispielsweise zur Kühlung von elektronischen Komponenten, wie Mikroprozessoren oder Chips, verwendet. Generell unterscheidet man aktive und passive Kühleinrichtungen. Bei aktiven Kühleinrichtungen werden Aggregate, wie z.B. Gebläse oder Ventilatoren, genutzt, um den Abtransport von Wärme mit Hilfe eines Fluidstromes zu unterstützen oder überhaupt erst zu ermöglichen. Der dabei erzeugte Fluidstrom strömt über einen Kühlkörper, der mit einer Wärmequelle gekoppelt ist und von dieser Abwärme aufnimmt. Bekannte Kühlkörper haben beispielsweise eine Rippen- oder Säulenstruktur und sind teilweise an der Oberfläche aufgerauht. Das den Kühlkörper um- bzw. durchströmende Fluid nimmt dabei die Wärme auf. Meistens wird als Fluid bei der Kühlung von Prozessoren Luft genutzt. Da Luft ein sehr schlechter Wärmeleiter ist, müssen die Kühlkörper verhältnismäßig groß ausgelegt werden, um über eine im Verhältnis zur Wärmeeinleitungsfläche große Wärmeabgabefläche zu haben. Zu diesem Zwecke ist in der älteren, nicht vorveröffentlichten deutschen Patentanmeldung Nr. 100 41 829 vorgeschlagen, daß die Wärmeabgabefläche wesentlich größer als die Wärmeeinleitungsfläche ist, was durch eine vorgegebene Strukturierung in Form von Kanälen und in Form von Furchen, die in Strömungsverbindung mit den Kanälen stehen, erreicht wird.

Kühlvorrichtungen mit einem Substrat, durch welche sich Kanäle hindurcherstrecken, sind auch aus der DE 196 19 060 A1 und der EP 0 308 576 A2 bekannt. Die Kanäle können dabei rechteckig oder kreisförmig sein.

Die DE 92 14 061 U1 beschreibt einen Kühlkörper, dessen Wärmeeinleitungsfläche zur Oberflächenvergrößerung Rippen und Furchen aufweist.

Ein Problem bei aktiven Wärmetauschervorrichtungen ist neben den großen Abmessungen der Energiebedarf für die Einrichtung zur Erzeugung des Fluidstromes. Für einen effektiven Wärmeübergang ergibt sich daraus ein verhältnismäßig hoher Leistungsverbrauch und meist auch Platzbedarf für die entsprechende Einrichtung, wie z.B. ein Gebläse. Hinzukommt, daß eine gute Wärmeübertragung von der Wärmeabgabefläche an das Fluid dann erfolgt, wenn die Wärmeabgabefläche gegenüber dem Fluidstrom einen relativ hohen Strömungswiderstand hat. Dies aber bedingt wiederum ein stärkeres Gebläse.

Aufgabe der Erfindung ist es daher, eine Wärmetauschervorrichtung zu schaffen, die bei geringem Strömungswiderstand eine hohe Wärmetauschleistung bringt. Dabei soll die Wärmetauschervorrichtung einen geringen Platzbedarf haben und auch bei Verwendung von Luft als Fluid eine gute Wärmeübertragung ermöglichen.

Diese Aufgabe wird durch die im Patentanspruch 1 angegebenen Merkmale gelöst. Vorteilhafte Ausgestaltungen und Weiterbildungen der Erfindung sind den Unteransprüchen zu entnehmen.

Das Grundprinzip der Erfindung besteht darin, daß von der Oberseite des Substrates abstehende Stege mit geringer Höhe vorgesehen sind, die quer zur Anströmungsrichtung des Fluides liegen, und daß im Substrat durchgehende Kanäle vorhanden sind.

Die Wärmeübertragung zwischen dem Fluid und dem Substrat erfolgt nur in einer dünnen Grenzschicht unmittelbar an der Oberfläche des Substrates. Zur Erhöhung der Wärmeübertragung wird das Fluid so geleitet, daß durch geometrische Merkmale des Substrates lokalisierte Turbulenzen erzeugt werden, die den Wärmeübertrag zwischen Fluid und Substrat erhöhen, ohne den Strömungswiderstand wesentlich zu erhöhen. Zur Erzeugung dieser Turbulenzen sind die regelmäßig angeordneten Stege, die als Mikrohindernisse wirken, vorgesehen und regelmäßig angeordneten Kanäle, die sich durch das Substrat hindurcherstrecken. Das Substrat ist im wesentlichen eine dünne Platte, die in geringem Abstand oberhalb der zu kühlenden heißen bzw. zu erwärmenden kalten Oberfläche eines Objektes angebracht wird. An den regelmäßig angeordneten Mikrohindernissen bilden sich Turbulenzen aus, die auf der Anströmseite der Mikrohindernisse vor allem im Bereich der Kanäle durch den Aufprall auf die Mikrohindernisse erzeugt werden. Darüber hinaus tritt eine Art inverser Kamineffekt auf, d.h. ein Teil des anströmenden Fluids gelangt von oberhalb der Platte durch den Kanal hindurch in die Nähe oder direkt auf die heiße bzw. kalte Oberfläche des Objektes, wo ebenfalls eine weitere effektive Kopplung von Wärme mit dem Fluid erfolgt.

Das Substrat muß in Strömungsrichtung nur wenige Kanäle und Stege (Mikrohindernisse) aufweisen. Vorzugsweise genügen drei in Strömungsrichtung hintereinanderliegende Kanäle und Stege, da Untersuchungen zeigten, daß der Wärmeübertrag im Bereich des zweiten und dritten Kanals in Strömungsrichtung maximal ist. In diesem Bereich nimmt das Fluid die meiste Wärme auf, was durch Expansion des Fluides auch dazu führt, daß es eine Beschleunigung erfährt, die den Abtransport des erwärmten Fluides unterstützt.

Das Substrat kann an der zu kühlenden heißen bzw. zu erwärmenden kalten Oberfläche des Objektes durch Abstandhalter angebracht werden, beispielsweise durch Schweißen, Kleben, Löten o.ä. Die Abstandhalter sind vorzugsweise ebenfalls Stege, die sich in Anströmrichtung längs des gesamten Substrates erstrecken, so daß sich zwischen dem Objekt und der Unterseite des Substrates ebenfalls Kanäle für das Fluid ergeben.

Vorzugsweise ist die Verbindung zwischen dem Substrat und der zu kühlenden bzw, zu erwärmenden Oberfläche aus wärmeleitendem Material. Das Substrat kann entweder aus wärmeleitendem Material, wie Aluminium, Kupfer o.ä., sein. Es kann aber auch aus anderem Material, wie z.B. Silizium, sein, das lediglich mit einer wärmeleitenden Schicht überzogen ist. Das Grundmaterial des Substrates braucht daher nicht selbst wärmeleitend zu sein.

Das Substrat mit den Stegen und ggf. den Kanälen kann durch herkömmliche Bearbeitungsverfahren, wie Fräsen oder Stanzen, beispielsweise bei Aluminiumplatten, hergestellt sein oder auch durch Ätz- oder Oberflächenbeschichtungsverfahren, wie im Falle von Silizium.

Bei einer Weiterbildung der Erfindung können am Anströmende und/oder am Abströmende des Substrates Leitbleche vorgesehen sein, um die Einströmung des Fluids in den Kanal zwischen dem Substrat und der zu kühlenden bzw. zu erwärmenden Oberfläche des Objektes zu unterstützen.

Nach einer Weiterbildung der Erfindung ist oberhalb des Substrates für die Ausbildung eines nach oben ebenfalls geschlossenen Kanals eine dünne Platte angeordnet, die vorzugsweise an der dem Substrat zugewandten Seite aufgerauht ist oder ebenfalls Stege hat entsprechend den Stegen des Substrates. Diese als obere Abdeckung wirkende Platte verbessert die Abströmung des Fluids insbesondere im letzten Abschnitt vor dem Auströmende.

Die Wärmetauschervorrichtungen nach der Erfindung können modulartig miteinander kombiniert werden, wobei eine Vielzahl von Anordnungen einzelner Module möglich sind.

Generell ist die Anströmrichtung im Inneren der Wärmetauschervorrichtung tangential zur Unterseite und zur Oberseite des Substrates. Die Zuströmung des Fluids zu den einzelnen Modulen kann aber auch senkrecht zur Unter- und Oberseite des Substrates erfolgen, wobei dann Mittel, wie z.B. Leitbleche, vorgesehen sind, um das anströmende Fluid umzulenken.

Im folgenden wird die Erfindung anhand eines Ausführungsbeispieles im Zusammenhang mit der Zeichnung ausführlicher erläutert. Es zeigt:
- Fig. 1: eine perspektivische Teilansicht einer Wärmetauschervorrichtung nach der Erfindung;
- Fig. 2: eine Draufsicht auf die Wärmetauschervor- richtung;
- Fig. 3: einen Querschnitt der Wärmetauschervorrich- tung längs der Linie A-A der Fig. 2;
- Fig. 4: ein Diagramm der Temperaturverteilung an der Wärmetauschervorrichtung;
- Fig. 5: ein Diagramm der Strömung des Fluides ent- lang der Wärmetauschervorrichtung;
- Fig. 6: eine Anordnung mehrerer Wärmetauschervor- richtungen nach der Erfindung, die modular erweiterbar ist;
- Fig. 7: eine andere Anordnung von Wärmetauschervor- richtungen in vertikaler Ausrichtung;
- Fig. 8: eine Anordnung von Wärmetauschervorrichtun- gen nach der Erfindung mit senkrechter Zu- strömung des Fluides zu dem Substrat;
- Fig. 9: eine perspektivische Ansicht ähnlich der Bauform der Fig. 8, jedoch mit einem Mate- rialkern im zentralen Bereich, auf dem ein Lüfter befestigt werden kann; und
- Fig. 10a-10c: eine stirnansicht, eine Draufsicht und einen Querschnitt der Anordnung der Fig. 9.

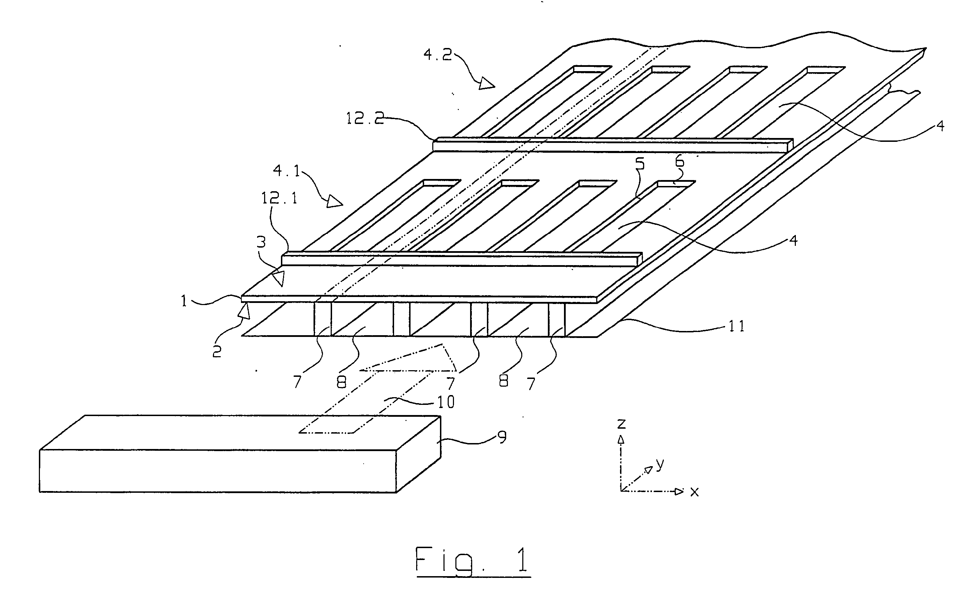

Zunächst sei auf Fig. 1 Bezug genommen. Ein Substrat 1 mit einer Unterseite 2 und einer Oberseite 3 hat eine Vielzahl von regelmäßig angeordneten, sich durch das Substrat 1 hindurcherstreckenden Kanälen 4, die hier rechteckig ausgebildet sind. Die Kanäle haben eine Längskante 5 und eine Querkante 6. Das Substrat 1 ist durch Abstandhalter 7 gegenüber der Oberfläche eines Objektes 11, mit dem Wärme ausgetauscht werden soll, gehalten, wobei sich die Abstandhalter 7 über die gesamte Länge des Substrates erstrecken. Es sind mehrere, parallel zueinander verlaufende Abstandhalter 7 vorgesehen, die jeweils so angeordnet sind, daß sie zwischen den Kanälen 4 liegen. Hierdurch werden zwischen dem Substrat 1, dem Objekt 11 und den Abstandhaltern 7 weitere Kanäle 8 gebildet, die längs des Substrates 1 verlaufen. Eine Einrichtung 9, die beispielsweise ein Gebläse sein kann, erzeugt einen gerichteten Fluidstrom, der in Richtung des Pfeiles 10, im folgenden Anströmrichtung 10 genannt, sowohl durch die Kanäle 8 strömt und damit längs der Unterseite 2 als auch längs der Oberfläche 3 des Substrates 1 und dabei teilweise auch durch die Kanäle 4 hindurch, und zwar teilweise in beiden Richtungen, d.h. von oben nach unten und an anderer Stelle von unten nach oben.

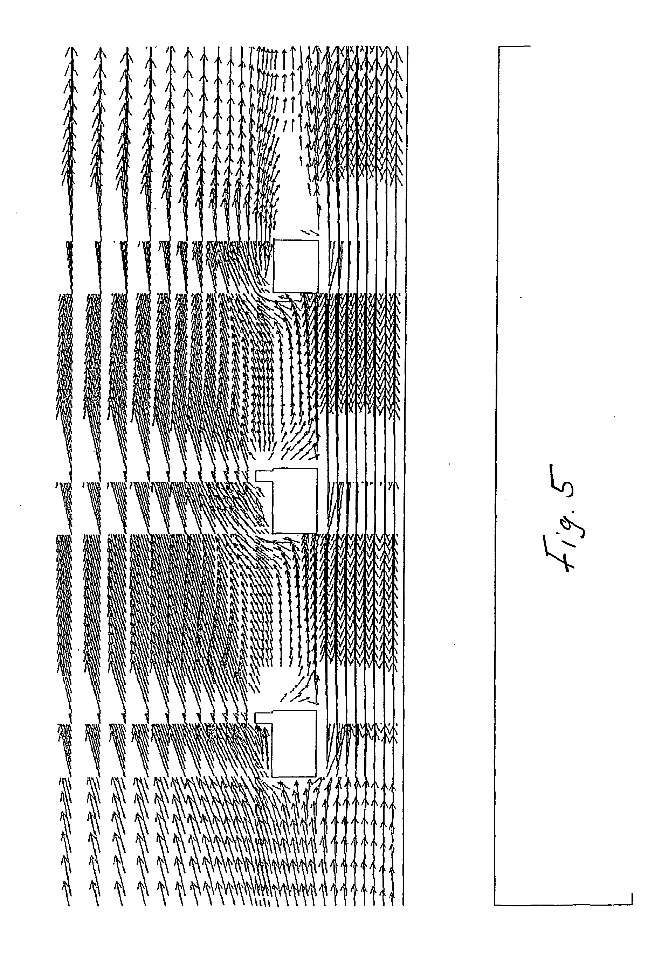

In Anströmrichtung 10 vor den Kanälen 4 sind quer zur Anströmrichtung 10 verlaufende Stege 12.1, 12.2 vorgesehen, die, wie am besten aus Fig. 5 zu erkennen ist, Turbulenzen erzeugen, die für den verbesserten Wärmeübertrag sorgen. Andererseits sind die Stege 12.1, 12.2 so niedrig, daß sie den Strömungswiderstand nur geringfügig erhöhen und deshalb auch als "Mikrohindernisse" bezeichnet werden.

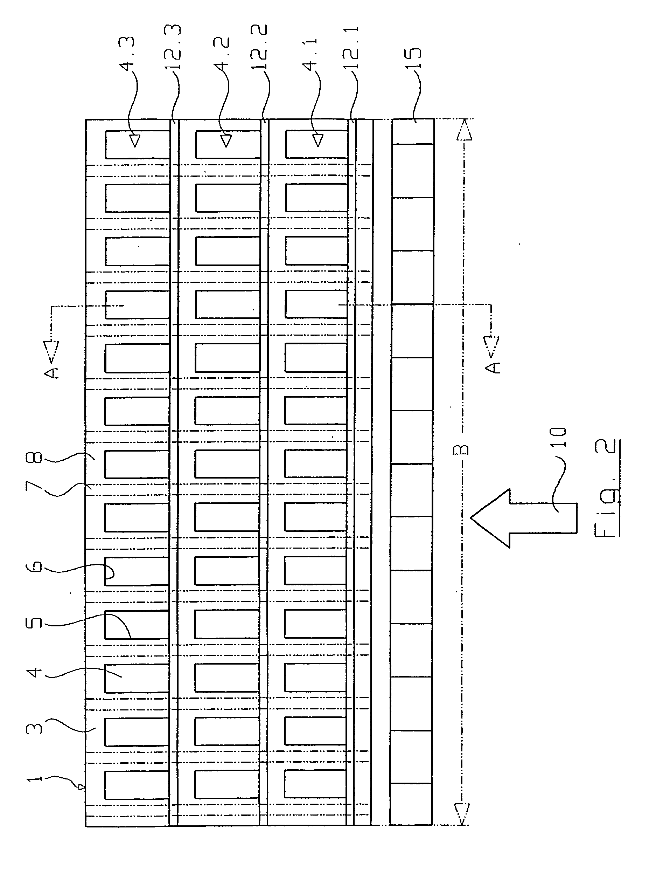

Aus der Draufsicht der Fig. 2 ist zu erkennen, daß das Substrat 1 drei in Strömungsrichtung 10 hintereinanderliegende Reihen 4.1, 4.2 und 4.3 von Kanälen 4 aufweist sowie drei in Anströmrichtung hintereinanderliegende Stege 12.1, 12.2 und 12.3, die jeweils in Anströmrichtung 10 vor den Reihen von Kanälen liegen. Zwischen den Kanälen 4 sind in Anströmrichtung 10 die Abstandhalter 7 angeordnet, die sich über die gesamte Länge des Substrates erstrecken.

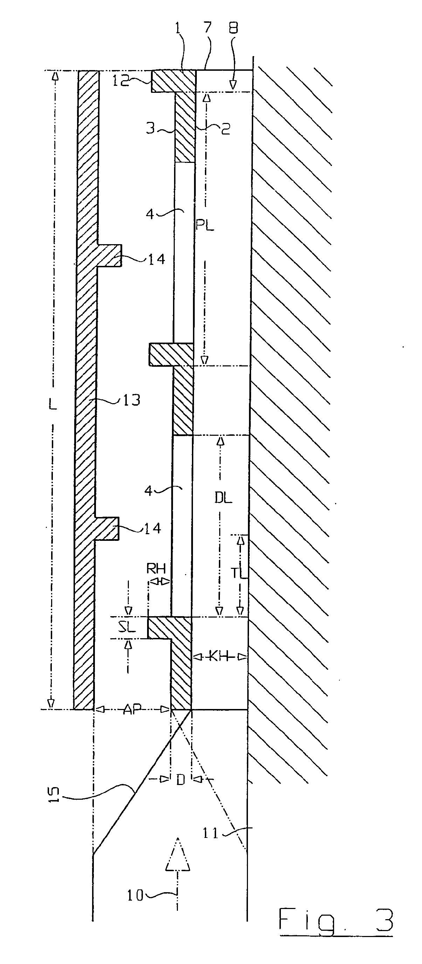

Aus der Schnittansicht der Fig. 3 ist zu erkennen, daß oberhalb des Substrates 1, also gegenüberliegend zu dessen Oberseite 3, eine Abdeckplatte 13 angeordnet sein kann, die in einem Abstand AP gegenüber der Oberseite 3 gehalten ist. Die der Oberseite 3 des Substrates 1 zugewandte Seite der Abdeckplatte 13 hat ebenfalls Stege 14, die für die Erzeugung von Turbulenzen wirksam sind. Statt der Stege oder zusätzlich hierzu kann auch die Fläche der Abdeckplatte 13, die dem Substrat 1 gegenüberliegt, aufgerauht sein. Der Abstand AP ist mindestens doppelt so groß wie die Höhe RH der Stege 12.

In einem konkreten Ausführungsbeispiel hat das Substrat in Anströmrichtung 10 eine Länge L von 16,5 mm und quer zur Anströmrichtung 10 eine Breite B (vgl. Fig. 2) von 58 mm. Die Kanäle 4 haben in Anströmrichtung eine Länge DL von 4 mm und quer dazu eine Breite von 2 mm. Die in Anströmrichtung 10 gemessene Länge SL der Stege 12 beträgt 0,3 mm; die Dicke D des Substrates beträgt 1 mm. Der Abstand KH, d.h. die Höhe der Kanäle 8 zwischen dem Substrat 1 und dem zu kühlenden Objekt 11 beträgt 2 mm. Die Höhe der Stege 12 beträgt im konkreten Ausführungsbeispiel 0,3 mm und darf maximal die Hälfte der Länge DL der Kanäle 4 sein. Bei dieser Konfiguration wurde bei einer Anströmgeschwindigkeit von ca. 5 m/s und einer Temperatur des zu kühlenden Gegenstandes von ca. 340°K eine Kühlleistung von ca. 20 W erzielt.

Mit einer solchen Wärmetauschervorrichtung kann außerdem eine Flächenvergrößerung für den verbesserten Wärmeübertrag gegenüber einer ebenen Fläche mit einem Faktor von mindestens 2 erreicht werden, da auch die Innenwandungen der Kanäle 4 und die Außenflächen der Stege 12 als Fläche für einen Wärmeübertrag wirksam sind.

Aus den Figuren 2 und 3 ist noch zu erkennen, daß in Anströmrichtung vor dem Substrat 1 ein Leitblech 15 angeordnet sein kann, das hier gewellt ist und somit für eine definierte Verteilung des Fluidstromes längs der Ober- und der Unterseite des Substrates sorgt.

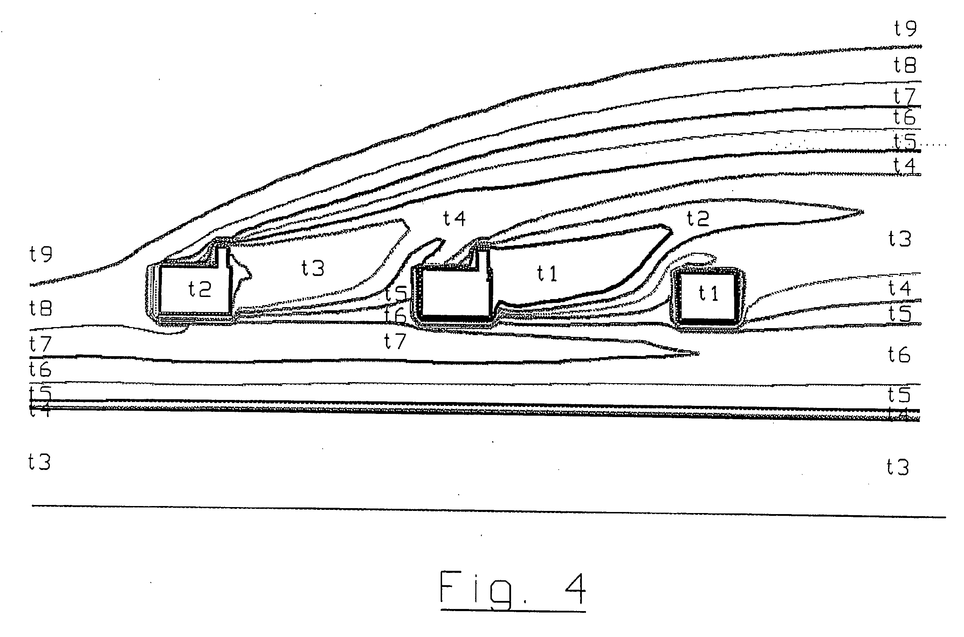

Fig. 4 zeigt die Temperaturverteilung an dem Substrat im Bereich der Kanäle 4 und der Stege 12 anhand von Isothermen t1-t9, wobei in Anströmrichtung 10 am dritten Kanal (rechts in Fig. 4) kein Steg vorhanden ist, um die Wirkung der Stege zu verdeutlichen. Die Temperaturdifferenz zwischen benachbarten Isothermen t1-t9 liegt bei ca. 4°K, wobei die höchste Temperatur t1 bei ca. 342°K und die niedrigste Temperatur t9 bei ca. 308°K liegt. In den Bereichen, in denen die Isothermen sehr eng beieinanderliegen, also der größte Temperaturgradient auftritt, ist der größte Wärmeübertrag vorhanden. Aus Fig. 4 ergibt sich deutlich, daß dieser gerade im Bereich der Stege auftritt sowie jeweils an der Kante des Substrates an der stromaufwärtigen Seite der Kanäle 4. An diesen beiden Stellen sowie an der Unterseite des Substrates tritt eine Verwirbelung der Strömung auf, was den besten Wärmeübertrag bringt. Auch ist erkennbar, daß der Wärmeübertrag im Bereich der ersten beiden Kanäle in Anströmrichtung am besten ist und dann in Anströmrichtung 10 abnimmt, da das Fluid beim Passieren des Substrates erwärmt wird und damit eine schlechtere Kühlleistung bringt.

Fig. 5 zeigt den Strömungsverlauf des Fluides längs des Substrates. Es ist zu erkennen, daß in Anströmrichtung hinter den Stegen auch eine abwärts gerichtete Strömungskomponente vorhanden ist. Weiter ist zu erkennen, daß aufgrund der Expansion von erwärmter Luft eine Beschleunigung der Strömung auftritt.

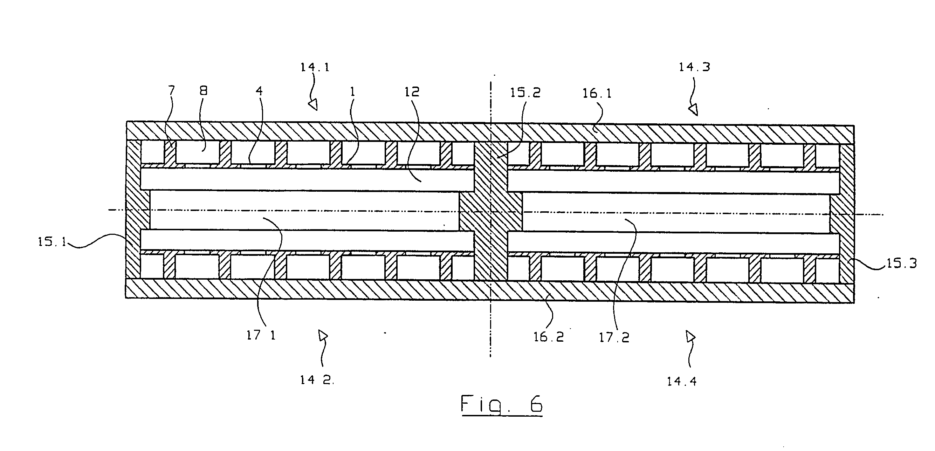

Eine einzelne Wärmetauschervorrichtung gemäß den bisher beschriebenen Ausführungsbeispielen der Figuren 1-5 sei im folgenden als Modul 14 bezeichnet. Fig. 6 zeigt ein Ausführungsbeispiel mit vier solchen Modulen 14.1-14.4, die je paarweise einander so gegenüberliegen, daß die Stege 12 aufeinanderzuweisen, wobei hier zwei Paare 14.1, 14.2 und 14.3, 14.4 nebeneinander angeordnet sind. Die einzelnen Module werden durch Abstandhalter 15.1, 15.2 und 15.3 positioniert und durch Abdeckplatten 16.1 und 16.2, die zusammen mit den seitlichen Abstandhaltern 15.1 und 15.3 ein rechteckiges Gehäuse bilden, zu einer kompakten Baueinheit zusammengehalten. Diese Baueinheit bildet einen breiten Schacht 17.1, 17.2, durch den das Wärmetauscherfluid strömt, sowie durch die Kanäle 4 und 8. Die Abstandhalter 15.1, 15.2 und 15.3 sind vorzugsweise aus wärmeleitendem Material, um die einzelnen Module thermisch miteinander zu koppeln. Die Anströmung mit dem Fluid, wie z.B. Luft, erfolgt in horizontaler Richtung parallel zu den Abdeckplatten 16.1 und 16.2, von denen eine im thermischen Kontakt mit dem nicht dargestellten zu kühlenden Objekt steht. Auch eine solche Baueinheit kann modular beliebig erweitert werden, indem mehrere solcher Baueinheiten übereinander gestappelt werden und/oder nebeneinander liegen.

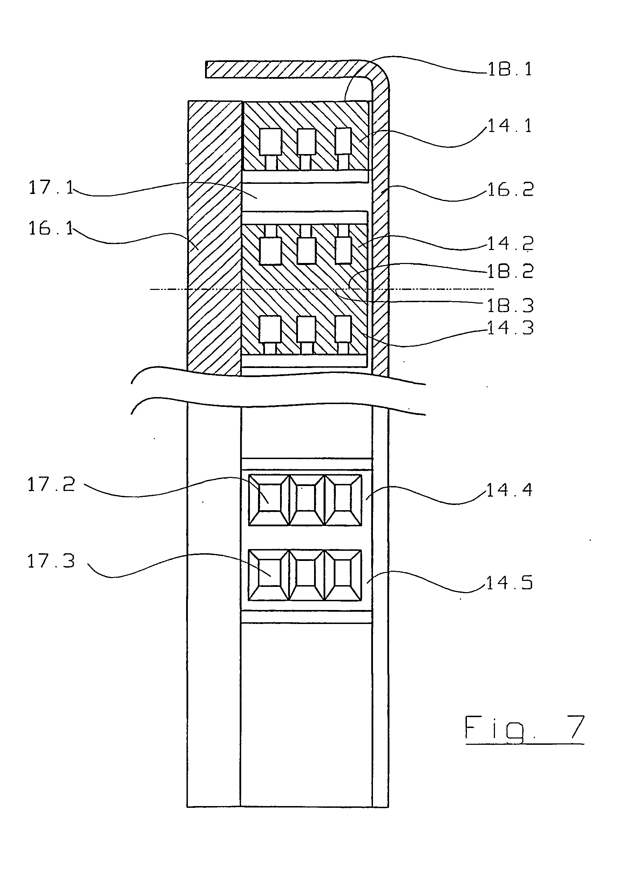

Fig. 7 zeigt eine gegenüber Fig. 6 abgewandelte Ausführungsform, bei der mehrere Module vertikal übereinander gestappelt sind. Die oberen drei Module 14.1-14.3 sind hierbei geschnitten dargestellt, während die beiden unteren dargestellten Module 14.4 und 14.5 eine Stirnansicht darstellen. Die Wärmeeinleitung erfolgt seitlich über eine Abdeckplatte 16.1. Weiter ist zu erkennen, daß einzelne Module, wie z.B. 14.2 und 14.3, sich mit ihren Substratrückseiten 18.2 und 18.3 unmittelbar berühren. Bei dieser Anordnung werden also mehrere übereinanderliegende Schächte 17.1...17.3 gebildet, die jeweils übereinander liegen und horizontal, d.h. senkrecht zur Zeichenebene der Fig. 7 angeströmt werden.

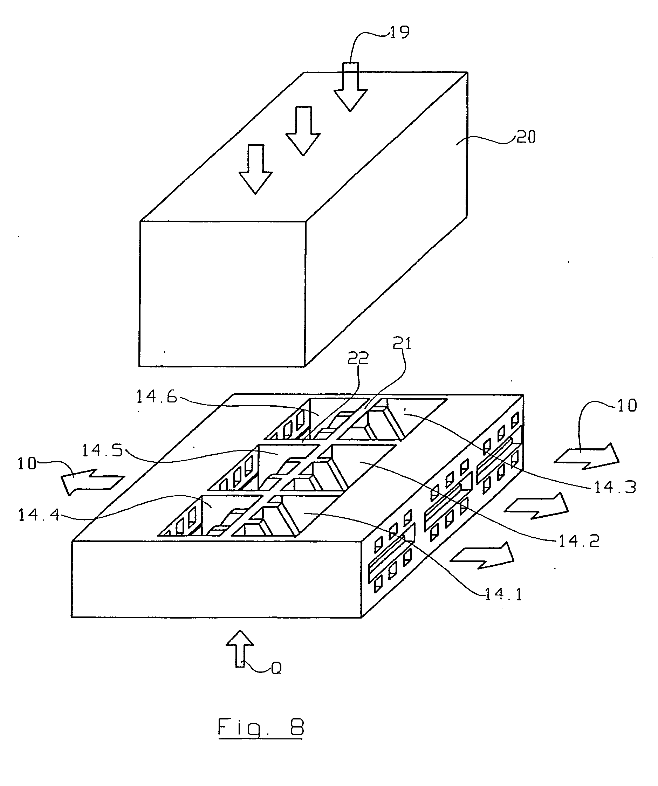

Fig. 8 zeigt eine Variante einer Anordnung mehrerer Module 14.1-14.6 in einem Gehäuse, wobei hier die Zuluft (vgl. Pfeil 19) vertikal zur Anströmrichtung 10 innerhalb der einzelnen Module zugeführt wird, was durch Strömungsleitbleche 20 und entsprechende Umlenkung in den einzelnen Modulen erfolgt. Die Abströmung (vgl. Pfeile 10) erfolgt hier nach zwei Seiten, da die einzelnen Module durch eine Längstrennwand 21 voneinander getrennt sind, wo sich die Zuluft 19 teilt. Auch können die einzelnen Module durch Quertrennwände 22 voneinander abgetrennt sein, um jeweils innerhalb eines Modules definierte Strömungsbedingungen zu gewährleisten. Die Wärmezufuhr erfolgt hier an der den Leitblechen 20 gegenüberliegenden Seite und ist durch den Pfeil Q angedeutet. Auch diese Ausführungsform ist in alle Richtungen (Breite, Länge und Höhe) beliebig erweiterbar. Das Fluid kann über Schläuche oder Rohre auch von einem entfernter gelegenen Lüfter herangeführt werden.

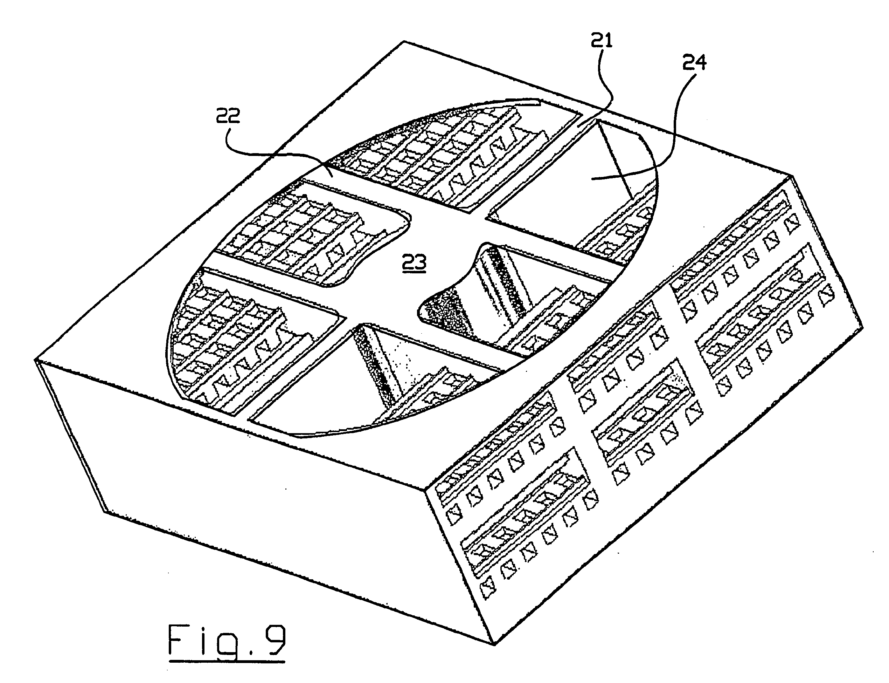

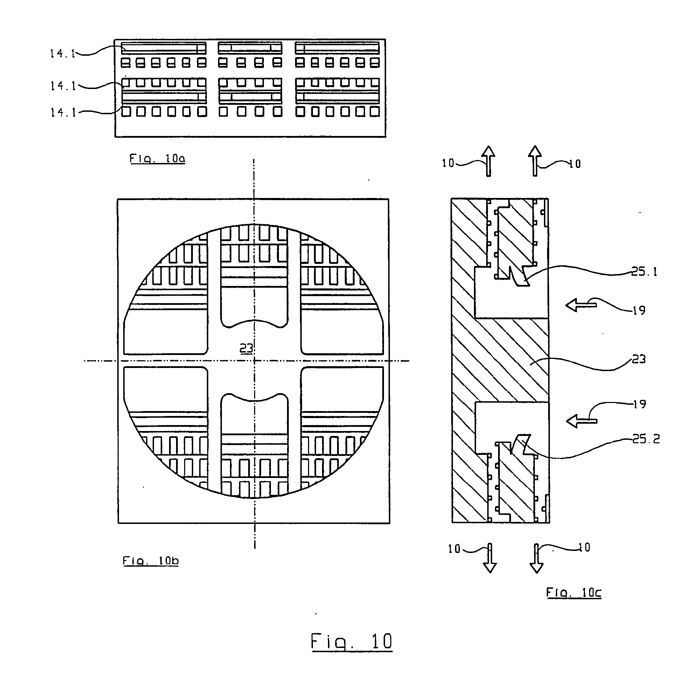

Fig. 9 und 10 zeigen eine gegenüber Fig. 8 etwas abgewandelte Ausführungsform, bei der im zentralen Bereich ein Materialkern 23 vorgesehen ist, auf den ein Lüfter montiert werden kann. Zufuhröffnungen 24 zu den einzelnen Modulen sind dann der Kontur des Lüfters angepaßt und bilden hier insgesamt annähernd eine Kreisform.

Wie aus Fig. 10a zu erkennen ist, sind hier mehrere Module seitlich nebeneinander und gleichzeitig vertikal übereinander angeordnet. Auch hier ist erkennbar, daß diese Bauform beliebig erweiterbar ist.

Aus der Schnittansicht der Fig. 10c ist noch zu erkennen, daß mehrere Module zu einer Baueinheit integriert werden können und daß bei der Anströmung (Pfeil 19) quer zur Abströmung (Pfeil 10) noch Leitbleche 25.1, 25.2 vorgesehen sein können, die einerseits die Strömung umlenken und andererseits auch auf einzelne Strömungswege aufteilen.

Generell ist noch zu bemerken, daß ein wesentlicher Vorzug der erfindungsgemäßen Wärmetauschervorrichtung darin liegt, daß sie bei gegenüber dem Stand der Technik deutlich verringertem Fluiddurchsatz eine gleiche oder bei gleichem Fluiddurchsatz eine bessere Kühlleistung erbringen. Hierdurch hat man geringeren Energieverbrauch der Lüfter, eine Geräuschverminderung, eine Gewichtsreduzierung und kleinere, billigere Lüfter, insgesamt einen geringeren Platzbedarf und damit auch geringere Logistikkosten.

Abschließend sei darauf hingewiesen, daß das Substrat mit den Kanälen und den Stegen allgemein als Wärmetauscher eingesetzt werden kann, also auch z.B. zum Erwärmen eines Objektes durch Anströmung mit einem heißen Medium oder zum gezielten Erwärmen eines Mediums (Fluid), z.B. eines Prozeßgases.

Weiter sei erwähnt, daß der Fluidstrom auch dadurch erzeugt werden kann, daß das Substrat und das zu kühlende oder zu erwärmende Objekt, an dem das Substrat angebracht ist, gegenüber einem Medium bewegt wird. Beispielsweise kann das Substrat an einem Fahrzeug, wie z.B. einem Auto oder einem Schiff, befestigt sein, bei dessen Fahrt der Fluidstrom entsteht.

Für die Dimensionierung der Kanäle 4 und 8 und der Stege 12 sowie der Abstandhalter 7 lassen sich noch folgende allgemeine Regeln aufstellen:

Die Länge der Turbulenzzone TL (Fig. 3) in Anströmrichtung 10 nach den Stegen 12 hängt primär von der Höhe RH der Stege 12 ab. Die Länge DL der Kanäle in Anströmrichtung sollte daher mindestens doppelt so groß sein wie die Höhe RH der Stege. Weiter soll die Höhe KH der Abstandhalter 7, d.h. der Abstand zwischen dem Substrat 1 und dem zu kühlenden Objekt 11 mindestens gleich oder größer der Länge SL der Stege sein. Auch soll die Höhe der Stege kleiner sein als der Abstand von in Anströmrichtung (10) benachbarten Stegen.

## Patentansprüche

1. Wärmetauschervorrichtung mit einem Substrat, das eine Unterseite und eine Oberseite aufweist,
mit einer Einrichtung (9) zur Erzeugung eines gerichteten Fluidstromes mit einer Anströmrichtung (10), die tangential zur Unterseite (2) und zur Oberseite (3) des Substrates (1) liegt,
mit von der Oberseite (3) des Substrates (1) abstehenden, in Anströmrichtung (10) hintereinander liegenden Stegen (12), deren Höhe kleiner ist als der Abstand (PL) von in Anströmrichtung (10) benachbarten Stegen, wobei die Stege (12) quer zur Anströmrichtung (10) angeordnet sind, und
wobei das Substrat (1) eine Vielzahl von regelmäßig angeordneten, sich durch das Substrat (1) hindurch erstreckenden Kanälen (4) aufweist,
**dadurch gekennzeichnet,**
**dass** das Substrat (1) durch Abstandhalter (7) an einem Objekt (11) angebracht ist,
**dass** die Höhe (KH) der Abstandhalter größer ist als die Höhe (RH) der Stege (12) und
**dass** die Höhe (KH) der Abstandhalter (7) kleiner ist als die Länge (DL) der Kanäle (4) in Anströmrichtung (10).

2. Wärmetauschervorrichtung nach Anspruch 1, **dadurch gekennzeichnet, dass** die Stege (12) sich durchgehend über die Breite (B) des Substrates (1) erstrecken.

3. Wärmetauschervorrichtung nach Anspruch 1 oder 2, **dadurch gekennzeichnet,**
**dass** die Stege (12) in Anströmrichtung (10) unmittelbar vor den Kanälen (4) angeordnet sind.

4. Wärmetauschervorrichtung nach einem der Ansprüche 1 bis 3, **dadurch gekennzeichnet,**
**dass** die Kanäle (4) rechteckige Form haben, wobei ihre längere Seite (5) parallel zur Anströmrichtung (10) ausgerichtet ist.

5. Wärmetauschervorrichtung nach Anspruch 1, **dadurch gekennzeichnet, dass** die Höhe (KH) der Abstandhalter (7) kleiner als 5 mm ist.

6. Wärmetauschervorrichtung nach Anspruch 1 oder 5, **dadurch gekennzeichnet,**
**dass** mehrere Abstandhalter (7) vorgesehen sind, die jeweils zwischen den Kanälen (4) von der Unterseite (2) des Substrates (1) abstehen und sich zur Bildung von Längskanälen (8) über die gesamte Länge des Substrates (1) erstrecken.

7. Wärmetauschervorrichtung nach einem der Ansprüche 1, 6 oder 7, **dadurch gekennzeichnet,**
**dass** die Abstandhalter (7) aus wärmeleitendem Material bestehen.

8. Wärmetauschervorrichtung nach einem der Ansprüche 1 bis 7, **dadurch gekennzeichnet,**
**dass** das Substrat (1) aus wärmeleitendem Material, insbesondere aus Metall besteht oder aus beliebigem Material, das mit wärmeleitendem Material beschichtet ist.

9. Wärmetauschervorrichtung nach einem der Ansprüche 1 bis 8, **dadurch gekennzeichnet,**
**dass** an der Anströmseite des Substrates (1) ein Leitblech (15) angeordnet ist.

10. Wärmetauschervorrichtung nach einem der Ansprüche 1 bis 9, **dadurch gekennzeichnet,**
**dass** im Abstand zur Oberseite (3) des Substrates (1) eine Abdeckplatte (13) angeordnet ist, wobei der Abstand (AP) der Abdeckplatte (13) zur Oberseite (3) des Substrates (1) mindestens das Doppelte der Höhe (RH) der Stege (12) ist.

11. Wärmetauschervorrichtung nach Anspruch 10, **dadurch gekennzeichnet, dass** die der Oberseite (3) des Substrates (1) zugewandte Seite der Abdeckplatte (13) Strömungshindernisse und insbesondere Stege (14) aufweist, die den Stegen (12) auf der Oberseite des Substrates (1) entsprechen.

12. Wärmetauschervorrichtung nach einem der Ansprüche 1 bis 11, **dadurch gekennzeichnet,**
**dass** mehrere Wärmetauschervorrichtungen modulartig nebeneinander und/oder übereinander und/oder hintereinander angeordnet sind.

13. Wärmetauschervorrichtung nach einem der Ansprüche 1 bis 12, **gekennzeichnet durch**
Leitbleche (20, 25), die so angeordnet sind, dass ein vertikal zur Anströmrichtung (10) der Stege (12) ankommender Fluidstrom (19) umgelenkt wird.

## Claims

1. Heat-exchanger device halving a substrate that comprises a bottom side and a top side, with a unit (9) for generating a directed fluid stream with a flow direction (10) that is tangential to the bottom side (2) and to the top side (3) of the substrate (1),
with webs (12) projecting from the top side (3) of the substrate (1), lying one after the other in the flow direction (10), wherein a height of the webs (12) is less than a spacing (PL) of adjacent webs in the flow direction (10), wherein the webs (12) are arranged perpendicular to the flow direction (10), and wherein the substrate (1) comprises a plurality of regularly arranged channels (4) extending through the substrate (1),
**characterized in that** the substrate (1) is attached to an object (11) by spacers (7), that the height (KH) of the spacers is greater than the height (RH) of the webs (12) and **in that** the height (KH) of the spacers (7) is less than the length (DL) of the channels (4) in the flow direction (10).

2. Heat-exchanger device according to claim 1, **characterized in that** the webs (12) extend continously over a width (B) of the substrate (1).

3. Heat-exchanger device according to claim 1 and 2, **characterized in that** the webs (12) are arranged directly in front of the channels (4) in the flow direction (10).

4. Heat-exchanger device according to one of claims 1 to 3, **characterized in that** the channels (4) have a rectangular shape with their longer side (5) is oriented parallel to the flow direction (10).

5. Heat-exchanger device according to claim 1, **characterized in that** the height (KH) of the spacers (7) is less than 5 mm.

6. Heat-exchanger device according to claims 1 or 5, **characterized in that** several spacers (7) are provided, each is extending from the lower side (2) of the substrate between the channels (4) and extending over the whole length of the substrate (1) to form longitudinal channels (8).

7. Heat-exchanger device according to one of claims 1, 6 or 7, **characterized in that** the spacers (7) consist of thermally conductive material.

8. Heat-exchanger device according to one of claims 1 to 7, **characterized in that** the substrate (1) consists of thermally conductive material, in particular of metal or of any material, which is coated with thermally conductive material.

9. Heat-exchanger device according to one of claims 1 to 8, **characterized in that** a guide plate (15) is arranged at an inflow side of the substrate (1).

10. Heat-exchanger device according to one of claims 1 to 9, **characterized in that** a cover plate (13) is arranged in a distance to the top side (3) of the substrate (1), wherein the distance (AP) of the cover plate (13) to the top side of the substrate (1) is at least twice the height (RH) of the webs (12).

11. Heat-exchanger device according to claim 10, **characterized in that that** side of the cover plate (13) directed to the top side (3) of the substrate (1) comprises flow obstacles and in particular webs (14) corresponding with the webs (12) on the top side of the substrate (1).

12. Heat-exchanger device according to claims 1 to 11, **characterized in that** several heat exchangers are modularly arranged side by side, and/or above the other and/or behind the other.

13. Heat-exchanger device according to claims 1 to 12, **characterized by** guide plates (20, 25) arranged such that a fluids stream (19) arriving perpendicular to the direction of flow (10) to the webs (12) is deflected.

## Revendications

1. Dispositif échangeur de chaleur avec un substrat qui présente un côté inférieur et un côté supérieur,
avec un dispositif (9) pour générer un courant de fluide dirigé avec un sens du courant (10) qui se trouve tangentiel par rapport au côté inférieur (2) et par rapport au côté supérieur (3) du substrat (1),
avec des nervures (12) dépassant du côté supérieur (3) du substrat (1), se trouvant les unes derrière les autres dans le sens du courant (10), dont la hauteur est inférieure à la distance (PL) entre des nervures (12) contiguës dans le sens du courant (10), les nervures (12) étant disposées transversalement par rapport au sens du courant (10), et
le substrat (1) présentant une pluralité de canaux (4) disposés régulièrement, qui s'étendent en traversant le substrat (1),
**caractérisé en ce que**
le substrat (1) est monté par des éléments d'écartement (7) sur un objet (11),
la hauteur (KH) des éléments d'écartement est supérieure à la hauteur (RH) des nervures (12) et
la hauteur (KH) des éléments d'écartement (7) est inférieure à la longueur (DL) des canaux (4) dans le sens du courant (10).

2. Dispositif échangeur de chaleur selon la revendication 1, **caractérisé en ce**
**que** les nervures (12) s'étendent en continu sur la largeur (B) du substrat (1).

3. Dispositif échangeur de chaleur selon l'une des revendications 1 ou 2, **caractérisé en ce**
**que** les nervures (12) sont disposées dans le sens du courant (10) directement avant les canaux (4).

4. Dispositif échangeur de chaleur selon l'une quelconque des revendications 1 à 3, **caractérisé en ce**
**que** les canaux (4) ont une forme rectangulaire, leur côté (5) le plus long étant orienté parallèlement au sens du courant (10).

5. Dispositif échangeur de chaleur selon la revendication 1, **caractérisé en ce**
**que** la hauteur (KH) des éléments d'écartement (7) est inférieure à 5 mm.

6. Dispositif échangeur de chaleur selon l'une des revendications 1 ou 5, **caractérisé en ce**
**que** plusieurs éléments d'écartement (7) sont prévus, lesquels dépassent respectivement entre les canaux (4) du côté inférieur (2) du substrat (1) et s'étendent pour la formation de canaux longitudinaux (8) sur toute la longueur du substrat (1).

7. Dispositif échangeur de chaleur selon l'une quelconque des revendications 1, 6 ou 7, **caractérisé en ce**
**que** les éléments d'écartement (7) se composent d'un matériau thermoconducteur.

8. Dispositif échangeur de chaleur selon l'une quelconque des revendications 1 à 7, **caractérisé en ce**
**que** le substrat (1) se compose de matériau thermoconducteur, en particulier de métal ou d'un matériau quelconque qui est revêtu de matériau thermoconducteur.

9. Dispositif échangeur de chaleur selon l'une quelconque des revendications 1 à 8, **caractérisé en ce**
**qu'**une tôle de guidage (15) est disposée sur le côté d'entrée du substrat (1).

10. Dispositif échangeur de chaleur selon l'une quelconque des revendications 1 à 9, **caractérisé en ce**
**qu'**une plaque de recouvrement (13) est disposée à distance du côté supérieur (3) du substrat (1), la distance (AP) entre la plaque de recouvrement (13) et le côté supérieur (3) du substrat (1) étant au moins le double de la hauteur (RH) des nervures (12).

11. Dispositif échangeur de chaleur selon la revendication 10, **caractérisé en ce**
**que** le côté de la plaque de recouvrement (13) tourné vers le côté supérieur (3) du substrat (1) présente des obstacles au courant et en particulier des nervures (14) qui correspondent aux nervures (12) sur le côté supérieur du substrat (1).

12. Dispositif échangeur de chaleur selon l'une quelconque des revendications 1 à 11, **caractérisé en ce**
**que** plusieurs dispositifs échangeurs de chaleur sont disposés de manière modulaire les uns à côté des autres et/ou les uns au-dessus des autres et/ou les uns derrière les autres.

13. Dispositif échangeur de chaleur selon l'une quelconque des revendications 1 à 12, **caractérisé par**
des tôles de guidage (20, 25) qui sont disposées de façon à dévier un courant de fluide (19) arrivant verticalement par rapport au sens du courant (10) des nervures (12).
